# EUROPEAN PATENT APPLICATION

(11) **EP 4 516 726 A1**
(43) Date of publication of application: **05.03.2025**
(21) Application number: 23799206.0
(22) Date of filing: 27.04.2023
(51) Int. Cl.: B81C 1/00, B81B 7/00, B81B 7/02, G01D 11/00

(54) **INERTIAL SENSOR PACKAGING METHOD AND INERTIAL SENSOR**

(30) Priority: 06.05.2022 CN 202210486467
(71) Applicant: Memsensing Microsystems (Suzhou, China) Co. Ltd, Suzhou, Jiangsu 215123 (CN)
(72) Inventor: AN, Lijia, Suzhou, Jiangsu 215123 (CN); ZHUANG, Ruifen, Suzhou, Jiangsu 215123 (CN); ZHANG, Pei, Suzhou, Jiangsu 215123 (CN)
(74) Representative: Nederlandsch Octrooibureau
(86) International application number: PCT/CN2023/091061
(87) International publication number: WO 2023/213220

(57) **Abstract**

Disclosed an inertial sensor packaging method and an inertial sensor, the inertial sensor packaging method comprises: steps: breaking the Si-O bond of at least one of the first dielectric part in the first bonding surface in the MEMS wafer and the second dielectric part in the second bonding surface in the cover wafer; aligning the first bonding surface with the second bonding surface and attaching thereof together, so that the first dielectric part and the second dielectric part are pre-bonded through a dangling bond to obtain a pre-bonded wafer; performing heat treatment on the pre-bonded wafer to achieve permanent bonding between the first dielectric part and the second dielectric part, as well as between the first metal part and the second metal part. The packaging method of inertial sensor and inertial sensor of the embodiments in the present application not only ensure the sealing of the MEMS structure, but also realize the electrical connection between the bonding surfaces, simplify the process steps, and take into account high efficiency and high reliability.

## Description

This application claims the benefit of China Patent Application "Packaging method for inertial sensors and inertial sensors", filed on May 6, 2022, with the application number 202210486467.6, the disclosures of which are incorporated by reference herein in their entirety.

### TECHNICAL FIELD

The present application relates to the field of sensor technology, and more specifically to a packaging method of an inertial sensor and an inertial sensor.

### BACKGROUND

Micro-Electro-Mechanical System (MEMS), also called micro electro mechanical system, micro system, micro machinery, etc., refers to high-tech devices with dimensions of several millimeters or even smaller. Many of current MEMS sensors contain movable parts, therefore a silicon wafer containing a cavity needs to be bonded to protect the movable structure. Currently, the more common bonding methods include glass fritting (glass frit), metal bonding, such as Al-Ge bonding, Au-Au bonding, etc. Glass fritting generally has a large bonding area, making it difficult to achieve miniaturization. The width of metal bonding can be reduced, but the production efficiency is relatively low. Generally, it is single wafer that is applied for bonding, and the melting of metal can easily cause overflow during metal eutectic bonding.

Conventional bonding methods, such as fusion bonding, can achieve high quality bonding between silicon dioxide and silicon or silicon dioxide under low pressure and low temperature conditions, but there is no electrical connection between the bonding surfaces, usually additional metal through holes are needed to achieve electrical conduction, which increases the difficulty of the process.

Therefore, it is necessary to provide a new inertial sensor packaging method and an inertial sensor to solve the above problems existing in the prior art.

### TECHNICAL ISSUES

The embodiments of the present application provide an inertial sensor packaging method and an inertial sensor, to solve a technical problem of the inertial sensor adopting a fusion bonding method that results in no electrical connection between bonding surfaces and a low efficiency of the fusion bonding method.

### TECHNICAL SOLUTIONS

The embodiments of the present application provide an inertial sensor packaging method and an inertial sensor.

In a first aspect, the embodiments of the present application provide an inertial sensor packaging method, comprising the steps:
S0: Providing a MEMS wafer and a cover wafer. The MEMS wafer comprises a plurality of MEMS structures and a first bonding surface, the cover wafer comprises a second bonding surface. The first bonding surface comprises a first dielectric part and a first metal part, the second bonding surface comprises a second dielectric part and a second metal part, and the first dielectric part is arranged around the side wall of the first metal part, the second dielectric part is arranged around the side wall of the second metal part. The material of the first dielectric part and the second dielectric part is silicon oxide or silicon, and the material of at least one of the first dielectric part and the second dielectric part is silicon oxide;
S1: Breaking the Si-O bond of at least one of the first dielectric part and the second dielectric part;
S2: Aligning and attach the first bonding surface with and the second bonding surface and attaching thereof together, so that the first dielectric part and the second dielectric part are pre-bonded through a dangling bond to obtain a pre-bonded wafer;
S3: Performing heat treatment on the pre-bonded wafer to achieve permanent bonding between the first dielectric part and the second dielectric part, as well as between the first metal part and the second metal part;
S4: Cutting the pre-bonded wafer to form a plurality of inertial sensor units.

In some embodiments, the material of both the first metal part and the second metal part is copper, and the step of performing heat treatment on the pre-bonded wafer to achieve permanent bonding between the first dielectric part and the second dielectric part, as well as between the first metal part and the second metal part in step S3 comprises: repeating the steps of steps S0 to step S2 to obtain a plurality of pre-bonded wafers, and perform batch-annealing treatment on the plurality of pre-bonded wafers to achieve permanent bonding between the first dielectric part and the second dielectric part, as well as between the first metal part and the second metal part. The beneficial effect is: annealing treatment can be carried out at low temperature, so that the first metal part and the second metal part can be bonded by diffusion, compared to the method of melt bonding in hight temperature directly without annealing treatment, annealing treatment greatly reduces the impact of the temperature on the device, and makes the surface flatness of the first bonding surface and the second bonding surface that need to be bonded is higher, thereby making the bonding more stable and better sealed; and batch annealing treatment can be performed on several pre-bonded wafers, compared with the single-wafer processing method in high-temperature melt bonding, batch annealing improves production efficiency and solves the problem of low production efficiency caused by traditional metal bonding methods.

In some embodiments, the annealing temperature during the annealing treatment in step S3 is controlled to be 100°C to 400°C. The beneficial effect is that the low temperature of bonding greatly reduces the effect of temperature on the device.

In some embodiments, the step of breaking the Si-O bond of at least one of the first dielectric part and the second dielectric part in step S1 comprise: after planarization treatment on the first bonding surface and the second bonding surface respectively, performing plasma bombardment treatment on the first bonding surface and the second bonding surface to break the Si-O bond of at least one of the first dielectric part and the second dielectric part. The beneficial effect is that it is helpful to break the Si-O bond of at least one of the first dielectric part and the second dielectric part.

In some embodiments, the step of planarization treatment on the first bonding surface and the second bonding surface respectively in step S1 further comprises: controlling the roughness of the first bonding surface and the second bonding surface after the planarization treatment to be less than 0.5 nm. The beneficial effect is that: it ensures the smoothness of the first bonding surface and the second bonding surface, so as to facilitate the attaching and adsorption between the first bonding surface and the second bonding surface, thereby making the first dielectric part and the second dielectric part can achieve pre-bonding better and faster through dangling bonds such as hydrogen bonds (-H) or hydroxyl bonds (-OH).

In some embodiments, the step of planarization treatment on the first bonding surface and the second bonding surface respectively in step S1 further comprises: controlling the height of the first metal part in the first bonding surface after the planarization treatment to be lower than the height of the first dielectric part, and controlling the height of the second metal part in the second bonding surface after the planarization treatment to be lower than the height of the second dielectric part. The beneficial effect is: it is helpful to make the first bonding surface and the second bonding surface adhere and adsorb together, so that the first dielectric part and the second dielectric part can achieve pre-bonding better and faster through dangling bonds such as hydrogen bonds (-H) or hydroxyl bonds (-OH). Also, the height of the first metal part in the first bonding surface is lower than the height of the first dielectric part, and the height of the second metal part in the second bonding surface is lower than the height of the second dielectric part, which is beneficial to reducing the risk of overflow of the first metal part and the second metal part during the heat treatment process.

In some embodiments, after planarization treatment on the first bonding surface and the second bonding surface respectively in step S1, the height difference between the first metal part and the first dielectric part is 0A~200A, the height difference between the second metal part and the second dielectric part is 0A~200A. The beneficial effect is that: it is helpful to make the first bonding surface and the second bonding surface adhere and adsorb together, and during the subsequent heat treatment process, the dielectric part and the metal part have different expansion coefficients due to heating, setting a height difference of 0A ~200A between the dielectric part and the metal part is conducive to keeping the two at the same height after expansion, so that there are no gaps in the bonded wafers, the bonding quality is optimized and the yield rate is improved.

In some embodiments, the step S0 further comprises a metal part setting step, the metal part setting step comprises: setting a plurality of first metal parts on the first bonding surface, and setting the plurality of first metal parts in an array on the first bonding surface; setting a plurality of second metal parts on the second bonding surface, and setting the plurality of second metal parts in an array on the second bonding surface.

In some embodiments, the step S0 further comprises a metal part setting step. The metal part setting step comprises: setting the first metal part shaped as a ring structure of at least N turns on the first bonding surface, setting the second metal part shaped as a ring structure at least N turns on the second bonding surface, and making N a positive integer greater than or equal to 1.

In some embodiments, the metal part setting step further comprises: if N is a positive integer greater than or equal to 2, the at least N turns of the first metal part is shaped as a concentric ring structure, and the at least N turns of the second metal part is shaped as a concentric ring structure.

In some embodiments, the metal part setting step further comprises: making the area of the first metal part larger than the area of the second metal part, or making the area of the second metal part larger than the area of the first metal part. The beneficial effect is that: it improves the attaching probability of the first metal part and the second metal part, so that the fault tolerance rate is higher when the first bonding surface and the second bonding surface are attached, and the impact on the device is reduced.

In some embodiments, the metal part setting step further comprises: making the ratio of the area of the first metal part to the area of the second metal part 2:1~4:1, or making the ratio of the area of the first metal part to the area of the second metal part 1:2~1:4. The beneficial effect is that: it improves the attaching probability of the first metal part and the second metal part, so that the fault tolerance rate is higher when the first bonding surface and the second bonding surface are attached, and the impact on the device is reduced.

In some embodiments, the metal part setting step further comprises: making the maximum width of the first metal part on the first bonding surface be 1 µm~10 µm, and making the maximum width of the second metal part on the second bonding surface be 1 µm~10 µm.

In some embodiments, the metal part setting step further comprises: making the width of the ring of the first metal part in the ring structure on the first bonding surface be 1µm~10µm, and making the width of the ring of the second metal part in the ring structure on the second bonding surface 1µm~10µm.

In some embodiments, the metal part setting step further comprises: making the distance between the adjacent ones of the first metal parts be 5 µm~20 µm, and making the distance between the adjacent ones of the second metal parts be 5 µm~20 µm.

In some embodiments, the metal part setting step further comprises: making the first metal part and the second metal part at least one of a circular structure, an elliptical structure, and a polygonal structure, the polygonal structure comprises a rectangular structure and a square structure.

In some embodiments, the metal part setting step further comprises: making the first metal part and the second metal part be at least one of a circular ring structure, an elliptical ring structure, and a polygonal ring structure, the polygonal ring structure comprising a rectangular ring structure and a square ring structure.

In some embodiments, between step S1 and S2 the method further comprises the step of electroplating a third metal part on the surface of the first metal part and the second metal part respectively, and making the melting point of the third metal part lower than the melting point of any one of the first metal part and the second metal part.

In a second aspect, the embodiments of the present application provide an inertial sensor, comprising a MEMS device and a cover. The MEMS device comprises a MEMS structure and a first bonding surface. The cover comprises a second bonding surface. The first bonding surface comprises a first dielectric part and a first metal part, the second bonding surface comprises a second dielectric part and a second metal part, and the first dielectric part is arranged around the side wall of the first metal part, the second dielectric part is arranged around the side wall of the second metal part. The material of the first dielectric part and the second dielectric part is silicon oxide or silicon, the material of at least one of the first dielectric part and the second dielectric part is silicon oxide; the first dielectric part and the second dielectric part are bonded, the first metal part and the second metal part are bonded.

In some embodiments, the material of both the first metal part and the second metal part is copper.

In some embodiments, the first bonding surface is provided with a plurality of first metal parts, and the plurality of first metal parts are arranged in an array on the first bonding surface; the second bonding surface is provided with a plurality of second metal parts, and the plurality of second metal parts are arranged in an array on the second bonding surface.

In some embodiments, the first bonding surface is provided with at least N turns of the first metal part shaped as a ring structure, the second bonding surface is provided with at least N turns of the second metal part shaped as a ring structure, and N is a positive integer greater than or equal to 1.

In some embodiments, if N is a positive integer greater than or equal to 2, at least N turns of the first metal part is shaped as a concentric ring structure, at least N turns of the second metal part is shaped as a concentric ring structure.

In some embodiments, the area of the first metal part is larger than the area of the second metal part, and the ratio of the area of the first metal part to the area of the second metal part is 2:1~4:1, or the area of the second metal part is larger than the area of the first metal part, and the ratio of the area of the first metal part to the area of the second metal part is 1:2∼1:4. The beneficial effect is that: it improves the attaching probability of the first metal part and the second metal part, so that the fault tolerance rate is higher when the first bonding surface and the second bonding surface are attached, and the impact on the device is reduced.

In some embodiments, the maximum width of the first metal part on the first bonding surface is 1 µm~10 µm, the maximum width of the second metal part on the second bonding surface is 1 µm~10 µm.

In some embodiments, the width of the ring of the first metal part in the ring structure on the first bonding surface is 1µm~10µm, the width of the ring of the second metal part in the ring structure on the second bonding surface is 1µm~10µm.

In some embodiments, the distance between the adjacent ones of the first metal parts is 5 µm~20 µm, the distance between the adjacent ones of the second metal parts is 5 µm~20 µm.

In some embodiments, the first metal part and the second metal part are at least one of a circular structure, an elliptical structure, and a polygonal structure, the polygonal structure comprises a rectangular structure and a square structure.

In some embodiments, the first metal part and the second metal part are at least one of a circular ring structure, an elliptical ring structure, and a polygonal ring structure, the polygonal ring structure comprising a rectangular ring structure and a square ring structure.

In some embodiments, the roughness of the first bonding surface and the second bonding surface are both less than 0.5 nm. It ensures the smoothness of the first bonding surface and the second bonding surface, so as to facilitate the attaching and adsorption between the first bonding surface and the second bonding surface, thereby making the first dielectric part and the second dielectric part can achieve pre-bonding better and faster through dangling bonds such as hydrogen bonds (-H) or hydroxyl bonds (-OH).

In some embodiments, the height of the first metal part is lower than the height of the first dielectric part in the first bonding surface, the height of the second metal part is lower than the height of the second dielectric part in the second bonding surface. It is helpful to make the first bonding surface and the second bonding surface adhere and adsorb together, so that the first dielectric part and the second dielectric part can achieve pre-bonding better and faster through dangling bonds such as hydrogen bonds (-H) or hydroxyl bonds (-OH). Also, the height of the first metal part in the first bonding surface is lower than the height of the first dielectric part, and the height of the second metal part in the second bonding surface is lower than the height of the second dielectric part, which is beneficial to reducing the risk of overflow of the first metal part and the second metal part during the heat treatment process.

In some embodiments, the height difference between the first metal part and the first dielectric part is 0A~200A, the height difference between the seceond metal part and the second dielectric part is 0A~200A. The beneficial effect is that: it is helpful to make the first bonding surface and the second bonding surface adhere and adsorb together, and during the subsequent heat treatment process, the dielectric part and the metal part have different expansion coefficients due to heating, setting a height difference of 0A ~200A between the dielectric part and the metal part is conducive to keeping the two at the same height after expansion, so that there are no gaps in the bonded inertial sensor, the product quality is optimized and the yield rate is improved.

In some embodiments, a third metal part is respectively provided on the surface of the first metal part and the second metal part, and the melting point of the third metal part is lower than the melting point of either of the first metal part and the second metal part.

### BENEFICIAL EFFECTS

The inertial sensor packaging method and inertial sensor of the embodiments in the present application not only ensure the sealing of the MEMS structure, but also realize the electrical connection between the bonding surfaces, simplify the process steps, and take into account high efficiency and high reliability.

The beneficial effect of the inertial sensor packaging method of the embodiments of the present application is that: the first dielectric part is arranged around the side wall of the first metal part, and the second dielectric part is arranged around the side wall of the second metal part, which makes the surface of the first metal part located in the first bonding surface exposed, and makes the surface of the second metal part located in the second bonding surface exposed, thereby reducing the risk of overflow of the first metal part and the second metal part during the heat treatment process, and also facilitating the alignment and adsorption of the first metal part and the second metal part to achieve permanent bonding in step S3; by breaking at least one Si-O bond in the first dielectric part and the second dielectric part in S1, it is beneficial to make the first bonding surface and the second bonding surface adhere and adsorb together in step S2, so that the first dielectric part and the second dielectric part can achieve pre-bonding better and faster through dangling bonds such as hydrogen bonds (-H) or hydroxyl bonds (-OH) at room temperature; and through the method of the pre-bonding in step S2 and the heat treatment in step S3, the first metal part and the second metal part are directly metal-bonded under the combined action of temperature and insulator pressure, which can form an electrical connection directly between the two bonded parts, so that not only the problem that there is no electrical connection between the bonding surfaces in fusion bonding method is solved, also if the electrical connection is added in the later stage, it will increase the process steps, increase the complexity of the process, and reduce the reliability, so it also solves the problem that metal is easy to overflow in the metal inter-fusion bonding method; meanwhile, this packaging method ensures the firmness of the bonding between the first bonding surface and the second bonding surface, improving the sealing of the MEMS structure, the invention simplifies the process steps and achieves high efficiency and high reliability.

The beneficial effect of the inertial sensor of the embodiments of the present application is that: the first dielectric part is arranged around the side wall of the first metal part, and the second dielectric part is arranged around the side wall of the second metal part, which makes the surface of the first metal part located in the first bonding surface exposed, and makes the surface of the second metal part located in the second bonding surface exposed, thereby reducing the risk of overflow of the first metal part and the second metal part during the heat treatment process, and also facilitating the alignment and adsorption of the first metal part and the second metal part to achieve permanent bonding in packaging process; by the material of the first dielectric part and the second dielectric part being silicon oxide or silicon, and the material of at least one of the first dielectric part and the second dielectric part being silicon oxide, it is beneficial to make the first bonding surface and the second bonding surface adhere and adsorb together, so that the first dielectric part and the second dielectric part can achieve pre-bonding better and faster through dangling bonds such as hydrogen bonds (-H) or hydroxyl bonds (-OH) at room temperature. The inertial sensor ensures the sealing of the MEMS structure effectively and achieves high reliability of MEMS structure.

Various aspects, features, advantages, etc. of the embodiments of the present invention will be described in detail below with reference to the accompanying drawings. The above aspects, features, advantages, etc. of the present invention will become clearer from the following detailed description in conjunction with the accompanying drawings.

With reference to the latter description and the accompanying drawings, particular embodiments of the present invention are disclosed in detail, indicating the manner in which the principles of the present invention may be employed. It should be understood that embodiments of the present invention are not thereby limited in scope. Within the spirit and terms of the appended claims, embodiments of the invention include many changes, modifications and equivalents.

Features described and/or illustrated with respect to one embodiment may be used in the same or similar manner in one or more other embodiments, in combination with features in other embodiments, or in place of features in other embodiments.

It should be emphasized that the term "comprise/contain" as used herein refers to the presence of a feature, whole, step or component, but does not exclude the presence or addition of one or more other features, whole, steps or components.

### BRIEF DESCRIPTION OF THE DRAWINGS

To describe technical solutions in embodiments of this application more clearly, the following briefly introduces the accompanying drawings for describing the embodiments. It is clear that the accompanying drawings in the following descriptions show merely some embodiments of this application, and a person skilled in the art may still derive other drawings from these accompanying drawings without creative efforts.
FIG. 1 is a schematic structural diagram of an inertial sensor in the prior art;
FIG. 2 is a schematic assembly diagram of the inertial sensor according to the embodiment of the present invention;
FIG. 3 is a schematic structural diagram of the first bonding surface of the MEMS wafer in the inertial sensor shown in FIG. 2;
FIG. 4 is a schematic structural diagram of the second bonding surface of the cover wafer in the inertial sensor shown in FIG. 2;
FIG. 5 is a flow chart of the inertial sensor packaging method according to the embodiment of the present invention.

### DETAILED DESCRIPTION

The above description is only an overview of the technical solution of the present invention, in order to be able to more clearly understand the technical means of the present invention, and can be implemented in accordance with the contents of the specification, and in order to make the above and other purposes, features and advantages of the present invention can be more obvious and easy to understand, the following specially cites some embodiments and with the accompanying drawings, the following is described in detail.

In the description of the present invention, it should be noted that unless otherwise specified and limited, terms such as "set," "connect," and "attach" should be broadly interpreted. For example, it can be a fixed connection or a detachable connection, or even an integral connection. It can be a mechanical connection, an electrical connection, or a communicative connection. It can be directly connected or indirectly connected through an intermediate medium. It can refer to either internal communication between two components or the interaction between the two components. Ordinary technicians in this field can understand the specific meanings of the above-mentioned terms in the present invention based on specific circumstances.

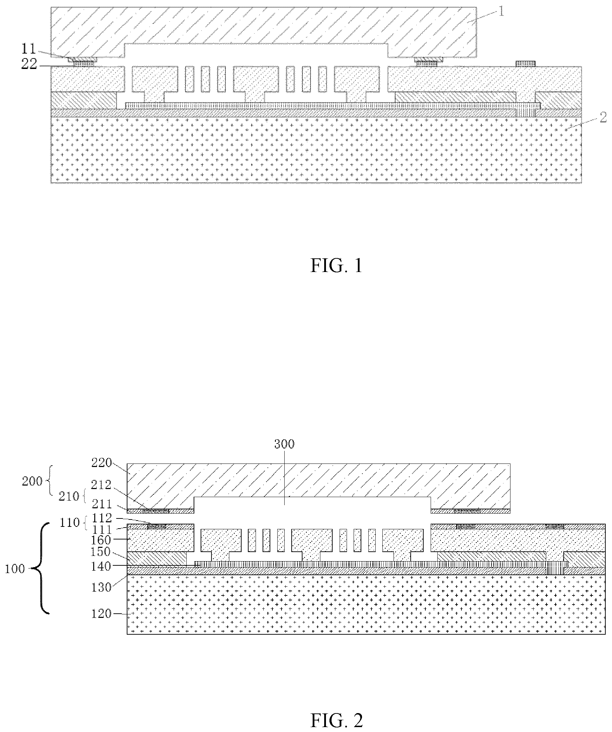

FIG. 1 is a schematic structural diagram of an inertial sensor in the prior art.

In the prior art, airtight bonding is usually achieved through metal fusion. Referring to FIG. 1, the germanium metal part 11 on the first wafer 1 and the aluminum metal part 22 on the second wafer 2 are bonded by metal melting, so that the first wafer 1 and the second wafer 2 are hermetically sealed. However, the metal fusion bonding method is inefficient, and due to the high temperature during metal fusion bonding, there is a risk of alloy overflow after melting.

In order to overcome the problems in the prior art, embodiments of the present invention provide a new method of packaging inertial sensor and an inertial sensor to achieve high efficiency and high reliability while ensuring the sealing of the MEMS structure by means of pre-bonding plus batch-annealing treatment.

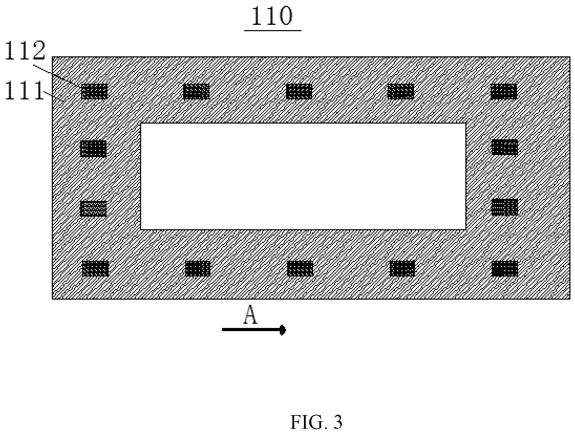

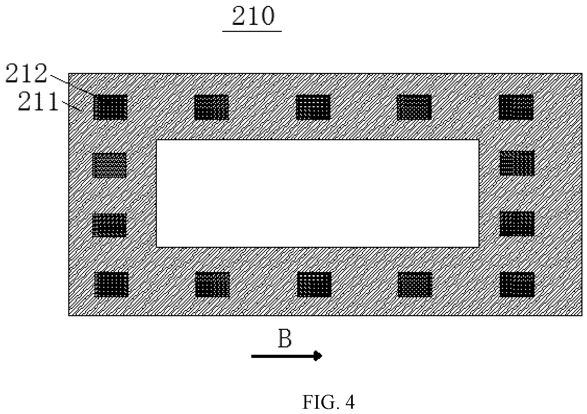

FIG. 2 is a schematic assembly diagram of the inertial sensor according to the embodiment of the present invention; FIG. 3 is a schematic structural diagram of the first bonding surface of the MEMS wafer in the inertial sensor shown in FIG. 2; FIG. 4 is a schematic structural diagram of the second bonding surface of the cover wafer in the inertial sensor shown in FIG. 2.

In some embodiments of the present invention, referring to FIG. 2 to FIG. 4, the inertial sensor comprises a MEMS device 100 and a cover 200. The MEMS device 100 comprises a first bonding surface 110 and a MEMS structure (not labeled in the figures), the cover 200 comprises a second bonding surface 210. The first bonding surface 110 comprises a first dielectric part 111 and a first metal part 112, the second bonding surface 210 comprises a second dielectric part 211 and a second metal part 212. The material of the first dielectric part 111 and the second dielectric part 211 is silicon oxide or silicon, the material of at least one of the first dielectric part 111 and the second dielectric part 211 is silicon oxide, it is beneficial to make the first bonding surface 110 and the second bonding surface 210 adhere and adsorb together, so that the first dielectric part 111 and the second dielectric part 211 can achieve pre-bonding better and faster through dangling bonds such as hydrogen bonds (-H) or hydroxyl bonds (-OH) at room temperature; the first dielectric part 111 and the second dielectric part 211 are bonded, and the first metal part 112 and the second metal part 212 are bonded. And the first dielectric part 111 is arranged around the side wall of the first metal part 112, the second dielectric part 211 is arranged around the side wall of the second metal part 212, which makes the surface of the first metal part 112 located in the first bonding surface 110 exposed, and makes the surface of the second metal part 212 located in the second bonding surface 210 exposed, thereby reducing the risk of overflow of the first metal part 112 and the second metal part 212 during the heat treatment process, and also facilitating the alignment and adsorption of the first metal part 112 and the second metal part 212 to achieve permanent bonding in packaging process. The inertial sensor ensures the sealing of the MEMS structure effectively and achieves high reliability of MEMS structure.

In some specific embodiments of the present invention, referring to FIG. 2, the MEMS device 100 further comprises a first monocrystalline silicon layer 120, a first silicon oxide layer 130, a first polycrystalline silicon layer 140, a second silicon oxide layer 150, and a second polycrystalline silicon layer 160 arranged sequentially from bottom to top. The cover 200 further comprises a second monocrystalline silicon layer 220. The MEMS device 100 and the cover 200 are bonded through the first bonding surface 110 and the second bonding surface 210 to form a closed cavity 300. Specifically, the structure of the MEMS device 100 and the cover 200 is common knowledge in the art and will not be repeated herein.

In some embodiments of the present invention, the material of both the first metal part 112 and the second metal part 212 is copper.

In some specific embodiments of the present invention, the material of the first dielectric part 111 and the second dielectric part 211 is silicon dioxide, and the material of the first metal part 112 and the second metal part 212 is copper.

In some embodiments of the present invention, the roughness of the first bonding surface 110 and the second bonding surface 210 are both less than 0.5 nm. It ensures the smoothness of the first bonding surface 110 and the second bonding surface 210, so as to facilitate the attaching and adsorption between the first bonding surface 110 and the second bonding surface 210, thereby making the first dielectric part 111 and the second dielectric part 211 can achieve pre-bonding better and faster through dangling bonds such as hydrogen bonds (-H) or hydroxyl bonds (-OH).

In some embodiments of the present invention, the height of the first metal part 112 is lower than the height of the first dielectric part 111 in the first bonding surface 110, the height of the second metal part 212 is lower than the height of the second dielectric part 211 in the second bonding surface 210. It is helpful to make the first bonding surface 110 and the second bonding surface 210 adhere and adsorb together, so that the first dielectric part 111 and the second dielectric part 211 can achieve pre-bonding better and faster through dangling bonds such as hydrogen bonds (-H) or hydroxyl bonds (-OH). Also, the height of the first metal part 112 in the first bonding surface 110 is lower than the height of the first dielectric part 111, and the height of the second metal part 212 in the second bonding surface 210 is lower than the height of the second dielectric part 211, which is beneficial to reducing the risk of overflow of the first metal part 112 and the second metal part 212 during the heat treatment process.

In some embodiments of the present invention, the height difference between the first metal part 112 and the first dielectric part 111 is 0A~200A, the height difference between the second metal part 212 and the second dielectric part 211 is 0A~200A. It is helpful to make the first bonding surface 110 and the second bonding surface 210 adhere and adsorb together, and during the subsequent heat treatment process, the dielectric part and the metal part have different expansion coefficients due to heating, setting a height difference of 0A ~200A between the dielectric part and the metal part is conducive to keeping the two at the same height after expansion, so that there are no gaps in the bonded inertial sensor, the product quality is optimized and the yield rate is improved.

In some embodiments of the present invention, a third metal part is respectively provided on the surface of the first metal part 112 and the second metal part 212, and the melting point of the third metal part is lower than the melting point of either of the first metal part 112 and the second metal part 212.

In some specific embodiments of the present invention, the material of the third metal part is tin-based alloy or indium-based alloy.

In some embodiments of the present invention, referring to FIG.2 to FIG. 4, the first bonding surface 110 is provided with a plurality of first metal parts 112, and the plurality of first metal parts 112 are arranged in an array on the first bonding surface 110; the second bonding surface 210 is provided with a plurality of second metal parts 212, and the plurality of second metal parts 212 are arranged in an array on the second bonding surface 210.

In some embodiments of the present invention, the maximum width of the first metal part on the first bonding surface is 1 µm~10 µm, the maximum width of the second metal part on the second bonding surface is 1 µm~10 µm.

In some embodiments of the present invention, the first metal part and the second metal part are at least one of a circular structure, an elliptical structure, and a polygonal structure, the polygonal structure comprises a rectangular structure and a square structure. That is, the structure of the first metal part in the first bonding surface 110 is a circular structure, a rectangular structure, a square structure or other polygonal structures. The structure of the second metal part in the second bonding surface is a circular structure, a rectangular structure, a square structure or other polygonal structures.

In some specific embodiments of the present invention, referring to FIG. 3 and FIG. 4, the cross-sections of the first metal part 112 and the second metal part 212 are both rectangular structures. The maximum width of the first metal part 112 in the first bonding surface 110 is the length of the first metal part 112, that is, the length in the direction indicated by A as shown in FIG. 3. The maximum width of the second metal part 212 in the second bonding surface 210 is the length of the second metal part 212, that is, the length in the direction indicated by B as shown in FIG. 4 .

In other specific embodiments of the present invention, both the first metal part 112 and the second metal part 212 are circular structures. The maximum width of the first metal part 112 in the first bonding surface 110 is the diameter of the first metal part 112, and the maximum width of the second metal part 212 in the second bonding surface 210 is the diameter of the second metal part 212.

In some other embodiments of the present invention, the first bonding surface 110 is provided with the first metal part 112 shaped as a ring structure of at least N turns, the second bonding surface 210 is provided with the second metal part 212 shaped as a ring structure of at least N turns, and N is a positive integer greater than or equal to 1.

In some embodiments of the present invention, if N is a positive integer greater than or equal to 2, at least N turns of the first metal part 112 is shaped as a concentric ring structure, at least N turns of the second metal part 212 is shaped as a concentric ring structure.

In some embodiments of the present invention, the width of the ring of the first metal part 112 in the ring structure on the first bonding surface 110 is 1µm~10µm, the width of the ring of the second metal part 212 in the ring structure on the second bonding surface 210 is 1µm~10µm.

In some embodiments of the present invention, the first metal part 112 and the second metal part 212 are at least one of a circular ring structure, an elliptical ring structure, and a polygonal ring structure, the polygonal ring structure comprising a rectangular ring structure and a square ring structure.

In some specific embodiments of the present invention, the first bonding surface 110 is provided with the first metal part 112 shaped as a ring structure of at least N turns, the second bonding surface 210 is provided with the second metal part 212 shaped as a ring structure of at least N turns, and N is a positive integer greater than or equal to 2. The first metal part 112 and the second metal part 212 are circular ring structure, and at least N rings of the first metal parts 112 in ring structure overlap at the center of the first bonding surface 110 to form a concentric ring structure, at least N rings of the second metal part 212 in the ring structure overlap at the center of the second bonding surface 210 to form a concentric ring structure.

In some embodiments of the present invention, the area of the first metal part is larger than the area of the second metal part, and the ratio of the area of the first metal part to the area of the second metal part is 2:1~4:1, or the area of the second metal part is larger than the area of the first metal part, and the ratio of the area of the first metal part 112 to the area of the second metal part 212 is 1:2∼1:4. It improves the attaching probability of the first metal part and the second metal part, so that the fault tolerance rate is higher when the first bonding surface and the second bonding surface are attached, and the impact on the device is reduced.

In some specific embodiments of the present invention, the area of the first metal part is larger than the area of the second metal part, and the ratio of the area of the first metal part to the area of the second metal part is 2:1~4:1.

In some specific embodiments of the present invention, the area of the second metal part is larger than the area of the first metal part, and the ratio of the area of the first metal part 112 to the area of the second metal part 212 is 1:2∼1:4.

In some other specific embodiments of the present invention, the area of the second metal part is equal to the area of the first metal part.

In some specific embodiments of the present invention, referring to FIG. 2 to IFG. 4, the area of the second metal part 212 is larger than the area of the first metal part 112.

In some embodiments of the present invention, the distance between the adjacent ones of the first metal parts is 5 µm~20 µm, the distance between the adjacent ones of the second metal parts is 5 µm~20 µm.

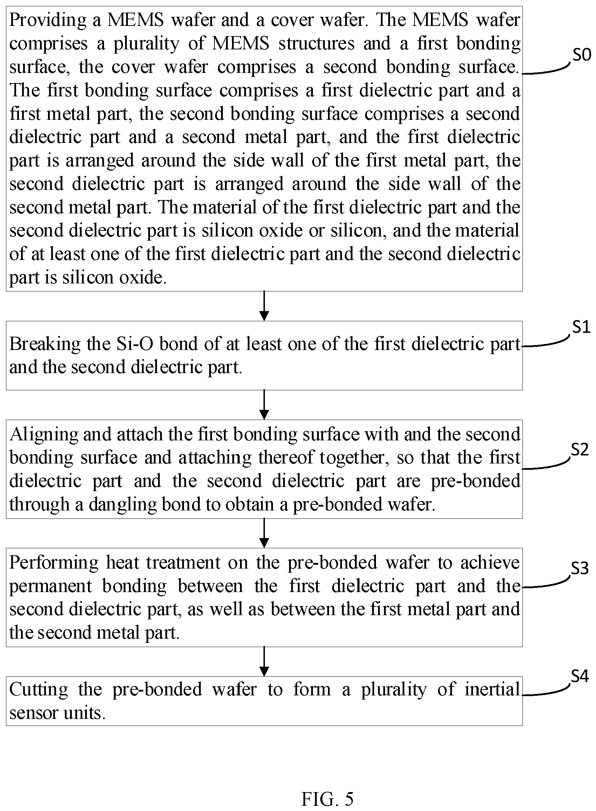

FIG. 5 is a flow chart of the inertial sensor packaging method according to the embodiment of the present invention.

In some embodiments of the present invention, referring to FIG. 5, the inertial sensor packaging method comprises the steps:
S0: Providing a MEMS wafer and a cover wafer. The MEMS wafer comprises a plurality of MEMS structures and a first bonding surface, the cover wafer comprises a second bonding surface. The first bonding surface comprises a first dielectric part and a first metal part, the second bonding surface comprises a second dielectric part and a second metal part, and the first dielectric part is arranged around the side wall of the first metal part, the second dielectric part is arranged around the side wall of the second metal part. The material of the first dielectric part and the second dielectric part is silicon oxide or silicon, and the material of at least one of the first dielectric part and the second dielectric part is silicon oxide;
S1: Breaking the Si-O bond of at least one of the first dielectric part and the second dielectric part;
S2: Aligning and attach the first bonding surface with the second bonding surface and attaching thereof together, so that the first dielectric part and the second dielectric part are pre-bonded through a dangling bond to obtain a pre-bonded wafer;
S3: Performing heat treatment on the pre-bonded wafer to achieve permanent bonding between the first dielectric part and the second dielectric part, as well as between the first metal part and the second metal part;
S4: Cutting the pre-bonded wafer to form a plurality of inertial sensor units.

Specifically, the first dielectric part is arranged around the side wall of the first metal part, and the second dielectric part is arranged around the side wall of the second metal part, which makes the surface of the first metal part located in the first bonding surface exposed, and makes the surface of the second metal part located in the second bonding surface exposed, thereby reducing the risk of overflow of the first metal part and the second metal part during the heat treatment process, and also facilitating the alignment and adsorption of the first metal part and the second metal part to achieve permanent bonding in step S3; by breaking at least one Si-O bond in the first dielectric part and the second dielectric part in S1, it is beneficial to make the first bonding surface and the second bonding surface adhere and adsorb together in step S2, so that the first dielectric part and the second dielectric part can achieve pre-bonding better and faster through dangling bonds such as hydrogen bonds (-H) or hydroxyl bonds (-OH) at room temperature; and through the method of the pre-bonding in step S2 and the heat treatment in step S3, the first metal part and the second metal part are directly metal-bonded under the combined action of temperature and insulator pressure, which can form an electrical connection directly between the two bonded parts, so that not only the problem that there is no electrical connection between the bonding surfaces in fusion bonding method is solved, also if the electrical connection is added in the later stage, it will increase the process steps, increase the complexity of the process, and reduce the reliability, so it also solves the problem that metal is easy to overflow in the metal inter-fusion bonding method; meanwhile, this packaging method ensures the firmness of the bonding between the first bonding surface and the second bonding surface, improving the sealing of the MEMS structure, the invention simplifies the process steps and achieves high efficiency and high reliability.

In some embodiments of the present invention, the material of both the first metal part and the second metal part is copper, and the step of performing heat treatment on the pre-bonded wafer to achieve permanent bonding between the first dielectric part and the second dielectric part, as well as between the first metal part and the second metal part in step S3 comprises: repeating the steps of steps S0 to step S2 to obtain a plurality of pre-bonded wafers, and perform batch-annealing treatment on the plurality of pre-bonded wafers to achieve permanent bonding between the first dielectric part and the second dielectric part, as well as between the first metal part and the second metal part. The annealing treatment can be carried out at low temperature, so that the first metal part and the second metal part can be bonded by diffusion, compared to the method of melt bonding in hight temperature directly without annealing treatment, annealing treatment greatly reduces the impact of the temperature on the device, and makes the surface flatness of the first bonding surface and the second bonding surface that need to be bonded is higher, thereby making the bonding more stable and better sealed; and batch annealing treatment can be performed on several pre-bonded wafers, compared with the single-wafer processing method in high-temperature melt bonding, batch annealing improves production efficiency and solves the problem of low production efficiency caused by traditional metal bonding methods.

In some embodiments of the present invention, the annealing temperature during the annealing treatment in step S3 is controlled to be 100°C to 400°C. The low temperature of bonding greatly reduces the effect of temperature on the device.

In some embodiments of the present invention, the step of breaking the Si-O bond of at least one of the first dielectric part and the second dielectric part in step S1 comprise: after planarization treatment on the first bonding surface and the second bonding surface respectively, performing plasma bombardment treatment on the first bonding surface and the second bonding surface to break the Si-O bond of at least one of the first dielectric part and the second dielectric part. It is helpful to break the Si-O bond of at least one of the first dielectric part and the second dielectric part.

In some embodiments of the present invention, the step of planarization treatment on the first bonding surface and the second bonding surface respectively in step S1 further comprises: controlling the roughness of the first bonding surface and the second bonding surface after the planarization treatment to be less than 0.5 nm. It ensures the smoothness of the first bonding surface and the second bonding surface, so as to facilitate the attaching and adsorption between the first bonding surface and the second bonding surface, thereby making the first dielectric part and the second dielectric part can achieve pre-bonding better and faster through dangling bonds such as hydrogen bonds (-H) or hydroxyl bonds (-OH).

In some embodiments of the present invention, the step of planarization treatment on the first bonding surface and the second bonding surface respectively in step S1 further comprises: controlling the height of the first metal part in the first bonding surface after the planarization treatment to be lower than the height of the first dielectric part, and controlling the height of the second metal part in the second bonding surface after planarization treatment to be lower than the height of the second dielectric part. It facilitates the attaching and adsorption between the first bonding surface and the second bonding surface, thereby making the first dielectric part and the second dielectric part can achieve pre-bonding better and faster through dangling bonds such as hydrogen bonds (-H) or hydroxyl bonds (-OH). Also, the height of the first metal part in the first bonding surface is lower than the height of the first dielectric part, and the height of the second metal part in the second bonding surface is lower than the height of the second dielectric part, which is beneficial to reducing the risk of overflow of the first metal part and the second metal part during the heat treatment process.

In some embodiments of the present invention, after planarization treatment on the first bonding surface and the second bonding surface respectively in step S1, the height difference between the first metal part and the first dielectric part is 0A~200A, the height difference between the second metal part and the second dielectric part is 0A~200A. It is helpful to make the first bonding surface and the second bonding surface adhere and adsorb together, and during the subsequent heat treatment process, the dielectric part and the metal part have different expansion coefficients due to heating, setting a height difference of 0A ~200A between the dielectric part and the metal part is conducive to keeping the two at the same height after expansion, so that there are no gaps in the bonded wafers, the bonding quality is optimized and the yield rate is improved.

In some embodiments of the present invention, the step S0 further comprises a metal part setting step, the metal part setting step comprises: setting a plurality of first metal parts on the first bonding surface, and setting the plurality of first metal parts in an array on the first bonding surface; setting a plurality of second metal parts on the second bonding surface, and setting the plurality of second metal parts in an array on the second bonding surface.

In some embodiments of the present invention, the metal part setting step further comprises: making the maximum width of the first metal part on the first bonding surface be 1 µm~10 µm, and making the maximum width of the second metal part on the second bonding surface be 1 µm~10 µm.

In some embodiments of the present invention, the metal part setting step further comprises: making the first metal part and the second metal part be shaped as at least one of a circular structure, an elliptical structure, and a polygonal structure, the polygonal structure comprises a rectangular structure and a square structure.

In some embodiments of the present invention, the step S0 further comprises a metal part setting step. The metal part setting step comprises: setting the first metal part shaped as a ring structure of at least N turns on the first bonding surface, setting the second metal part shaped as a ring structure of at least N turns on the second bonding surface, and N a positive integer greater than or equal to 1.

In some embodiments of the present invention, the metal part setting step further comprises: if N is a positive integer greater than or equal to 2, at least N turns of the first metal part is shaped as a concentric ring structure, and at least N turns of the second metal part is shaped as a concentric ring structure.

In some embodiments of the present invention, the metal part setting step further comprises: making the width of the ring of the first metal part in the ring structure on the first bonding surface be 1µm~10µm, and making the width of the ring of the second metal part in the ring structure on the second bonding surface 1µm~10µm.

In some embodiments of the present invention, the metal part setting step further comprises: making the first metal part and the second metal part be at least one of a circular ring structure, an elliptical ring structure, and a polygonal ring structure, the polygonal ring structure comprising a rectangular ring structure and a square ring structure.

In some embodiments of the present invention, the metal part setting step further comprises: making the area of the first metal part larger than the area of the second metal part, or making the area of the second metal part larger than the area of the first metal part. It improves the attaching probability of the first metal part and the second metal part, so that the fault tolerance rate is higher when the first bonding surface and the second bonding surface are attached, and the impact on the device is reduced.

In some embodiments of the present invention, the metal part setting step further comprises: making the ratio of the area of the first metal part to the area of the second metal part 2:1~4:1, or making the ratio of the area of the first metal part 112 to the area of the second metal part 212 1:2~1:4. It improves the attaching probability of the first metal part and the second metal part, so that the fault tolerance rate is higher when the first bonding surface and the second bonding surface are attached, and the impact on the device is reduced.

In some embodiments of the present invention, the metal part setting step further comprises: making the distance between the adjacent ones of the first metal parts be 5 µm~20 µm, and making the distance between the adjacent ones of the second metal parts be 5 µm~20 µm.

In some embodiments of the present invention, between step S1 and S2 further comprises the following step: A third metal part is respectively electroplated on the surface of the first metal part 112 and the second metal part 212, and the melting point of the third metal part is lower than the melting point of either of the first metal part 112 and the second metal part 212.

In some embodiments of the present invention, the inertial sensor is prepared by the inertial sensor packaging method. By means of pre-bonding plus batch annealing treatment, the sealing of the MEMS structure is effectively ensured, and the high reliability of the MEMS structure is realized.

Although the embodiments of the present invention have been described in detail above, it will be obvious to those skilled in the art that various modifications and changes can be made to these embodiments. However, it should be understood that such modifications and changes are within the scope and spirit of the invention as claimed. Furthermore, the invention described herein is capable of other embodiments and of being practiced or carried out in various ways.

## Claims

1. an inertial sensor packaging method, wherein the inertial sensor packaging method comprises the steps:
S0: providing a MEMS wafer and a cover wafer, the MEMS wafer comprises a plurality of MEMS structures and a first bonding surface, the cover wafer comprises a second bonding surface, the first bonding surface comprises a first dielectric part and a first metal part, the second bonding surface comprises a second dielectric part and a second metal part, and the first dielectric part is arranged around the side wall of the first metal part, the second dielectric part is arranged around the side wall of the second metal part, the material of the first dielectric part and the second dielectric part is silicon oxide or silicon, and the material of at least one of the first dielectric part and the second dielectric part is silicon oxide;
S1: breaking the Si-O bond of at least one of the first dielectric part and the second dielectric part;
S2: aligning the first bonding surface with the second bonding surface and attaching thereof together, so that the first dielectric part and the second dielectric part are pre-bonded through a dangling bond to obtain a pre-bonded wafer;
S3: performing heat treatment on the pre-bonded wafer to achieve permanent bonding between the first dielectric part and the second dielectric part, as well as between the first metal part and the second metal part;
S4: cutting the pre-bonded wafer to form a plurality of inertial sensor units.

2. The inertial sensor packaging method according to claim 1, wherein the material of both the first metal part and the second metal part is copper, and the step of performing heat treatment on the pre-bonded wafer to achieve permanent bonding between the first dielectric part and the second dielectric part, as well as between the first metal part and the second metal part in step S3 comprises:
repeating the steps of steps S0 to step S2 to obtain a plurality of pre-bonded wafers, and perform batch annealing treatment on the plurality of pre-bonded wafers to achieve permanent bonding between the first dielectric part and the second dielectric part, as well as between the first metal part and the second metal part.

3. The inertial sensor packaging method according to claim 2, wherein the annealing temperature during the annealing treatment in step S3 is controlled to be 100°C to 400°C.

4. The inertial sensor packaging method according to claim 1, wherein the step of breaking the Si-O bond of at least one of the first dielectric part and the second dielectric part in step S1 comprise:
after planarization treatment on the first bonding surface and the second bonding surface respectively, performing plasma bombardment treatment on the first bonding surface and the second bonding surface to break the Si-O bond of at least one of the first dielectric part and the second dielectric part.

5. The packaging method of inertial sensor according to claim 4, wherein the step of planarization treatment on the first bonding surface and the second bonding surface respectively in step S1 further comprises:
controlling the roughness of the first bonding surface and the second bonding surface after the planarization treatment to be less than 0.5 nm.

6. The inertial sensor packaging method according to claim 4, wherein the step of planarization treatment on the first bonding surface and the second bonding surface respectively in step S1 further comprises:
controlling the height of the first metal part in the first bonding surface after the planarization treatment to be lower than the height of the first dielectric part, and controlling the height of the second metal part in the second bonding surface after planarization treatment to be lower than the height of the second dielectric part.

7. The packaging method of inertial sensor according to claim 6, wherein after planarization treatment on the first bonding surface and the second bonding surface respectively in step S1, the height difference between the first metal part and the first dielectric part is 0A~200A, the height difference between the second metal part and the second dielectric part is 0A~200A.

8. The packaging method of inertial sensor according to claim 1, wherein the step S0 further comprises a metal part setting step, the metal part setting step comprises:
setting a plurality of first metal parts on the first bonding surface, and setting the plurality of first metal parts in an array on the first bonding surface; setting a plurality of second metal parts on the second bonding surface, and setting the plurality of second metal parts in an array on the second bonding surface.

9. The packaging method of inertial sensor according to claim 1, wherein the step S0 further comprises a metal part setting step, the metal part setting step comprises:
setting the first metal part shaped as a ring structure of at least N turns on the first bonding surface, setting the second metal part shaped as a ring structure of at least N turns on the second bonding surface, and N a positive integer greater than or equal to 1.

10. The packaging method of inertial sensor according to claim 9, wherein the metal part setting step further comprises:
if N is a positive integer greater than or equal to 2, the at least N turns of the first metal part is shaped as a concentric ring structure, and the at least N turns of the second metal part is shaped as a concentric ring structure.

11. The packaging method of inertial sensor according to claim 8 or 9, wherein the metal part setting step further comprises:
making the area of the first metal part larger than the area of the second metal part, or making the area of the second metal part larger than the area of the first metal part.

12. The packaging method of inertial sensor according to claim 11, wherein the metal part setting step further comprises:
making the ratio of the area of the first metal part to the area of the second metal part 2:1~4:1, or making the ratio of the area of the first metal part to the area of the second metal part 1:2~1:4.

13. The packaging method of inertial sensor according to claim 8, wherein the metal part setting step further comprises:
making the maximum width of the first metal part on the first bonding surface be 1 µm~10 µm, and making the maximum width of the second metal part on the second bonding surface be 1 µm~10 µm.

14. The packaging method of inertial sensor according to claim 9, wherein the metal part setting step further comprises:
making the width of ring of the first metal part in ring structure on the first bonding surface be 1µm~10µm, and making the width of ring of the second metal part in ring structure on the second bonding surface 1µm~10µm.

15. The packaging method of inertial sensor according to claim 8 or 9, wherein the metal part setting step further comprises:
making the distance between the adjacent ones of the first metal parts be 5 µm~20 µm, and making the distance between the adjacent ones of the second metal parts be 5 µm~20 µm.

16. The packaging method of inertial sensor according to claim 8, wherein the metal part setting step further comprises:
making the first metal part and the second metal part be shaped as at least one of a circular structure, an elliptical structure, and a polygonal structure, the polygonal structure comprises a rectangular structure and a square structure.

17. The packaging method of inertial sensor according to claim 9, wherein the metal part setting step further comprises:
making the first metal part and the second metal part be shaped as at least one of a circular ring structure, an elliptical ring structure, and a polygonal ring structure, the polygonal ring structure comprises a rectangular ring structure and a square ring structure.

18. The inertial sensor packaging method according to claim 1, wherein between step S1 and S2 the method further comprises the step:
electroplating a third metal part on the surface of the first metal part and the second metal part respectively, and making the melting point of the third metal part lower than the melting point of any one of the first metal part and the second metal part.

19. An inertial sensor, wherein the inertial sensor comprising a MEMS device and a cover, the MEMS device comprises a MEMS structure and a first bonding surface, the cover comprises a second bonding surface, the first bonding surface comprises a first dielectric part and a first metal part, the second bonding surface comprises a second dielectric part and a second metal part, and the first dielectric part is arranged around the side wall of the first metal part, the second dielectric part is arranged around the side wall of the second metal part, the material of the first dielectric part and the second dielectric part is silicon oxide or silicon, the material of at least one of the first dielectric part and the second dielectric part is silicon oxide; the first dielectric part and the second dielectric part are bonded, the first metal part and the second metal part are bonded.

20. The inertial sensor according to claim 19, wherein the material of both the first metal part and the second metal part is copper.

21. The inertial sensor according to claim 19, wherein the first bonding surface is provided with a plurality of first metal parts, and the plurality of first metal parts are arranged in an array on the first bonding surface; the second bonding surface is provided with a plurality of second metal parts, and the plurality of second metal parts are arranged in an array on the second bonding surface.

22. The inertial sensor according to claim 19, wherein the first bonding surface is provided with the first metal part shaped as a ring structure of at least N turns , the second bonding surface is provided with the second metal portion shaped as a ring structure of at least N turns, and N is a positive integer greater than or equal to 1.

23. The inertial sensor according to claim 22, wherein if N is a positive integer greater than or equal to 2, at least N turns of the first metal part is shaped as a concentric ring structure, at least N turns of the second metal part is shaped as a concentric ring structure.

24. The inertial sensor according to claim 21 or 22, wherein the area of the first metal part is larger than the area of the second metal part, and the ratio of the area of the first metal part to the area of the second metal part is 2:1~4:1, or the area of the second metal part is larger than the area of the first metal part, and the ratio of the area of the first metal part to the area of the second metal part is 1:2∼1:4.

25. The inertial sensor according to claim 21, wherein the maximum width of the first metal part on the first bonding surface is 1 µm~10 µm, the maximum width of the second metal part on the second bonding surface is 1 µm~10 µm.

26. The inertial sensor according to claim 22, wherein the width of the ring of the first metal part in the ring structure on the first bonding surface is 1µm~10µm, the width of the ring of the second metal part in the ring structure on the second bonding surface is 1µm~10µm.

27. The inertial sensor according to claim 21 or 22, wherein the distance between the adjacent ones of the first metal parts is 5 µm~20 µm, the distance between the adjacent ones of the second metal parts is 5 µm~20 µm.

28. The inertial sensor according to claim 21, wherein the first metal part and the second metal part are at least one of a circular structure, an elliptical structure, and a polygonal structure, the polygonal structure comprises a rectangular structure and a square structure.

29. The inertial sensor according to claim 22, wherein the first metal part and the second metal part are at least one of a circular ring structure, an elliptical ring structure, and a polygonal ring structure, the polygonal ring structure comprising a rectangular ring structure and a square ring structure.

30. The inertial sensor according to claim 19, wherein the roughness of the first bonding surface and the second bonding surface are both less than 0.5 nm.

31. The inertial sensor according to claim 19, wherein the height of the first metal part is lower than the height of the first dielectric part in the first bonding surface, the height of the second metal part is lower than the height of the second dielectric part in the second bonding surface.

32. The inertial sensor according to claim 31, wherein the height difference between the first metal part and the first dielectric part is 0A~200A, the height difference between the second metal part and the second dielectric part is 0A~200A.

33. The inertial sensor according to claim 19, wherein a third metal part is respectively provided on the surface of the first metal part and the second metal part, and the melting point of the third metal part is lower than the melting point of either of the first metal part and the second metal part.
